# EUROPÄISCHE PATENTANMELDUNG

(11) **EP 0 938 253 A1**
(43) Veröffentlichungstag der Anmeldung: **25.08.1999**
(21) Anmeldenummer: 99103220.2
(22) Anmeldetag: 18.02.1999
(51) Int. Cl.: H05K 7/14

(54) **Monitor und tastatur einschub**

(30) Priorität: 20.02.1998 DE 19807234
(71) Anmelder: Knürr Mechanik für die Elektronik AG, D-81829 München (DE)
(72) Erfinder: Schaerer, Erwin, 89125 Langenau (DE); Müller, Peter, 85655 Grosshelfendorf (DE); Keil, Christian, 82282 Pischertshofen (DE); Klein, Alexander, 82256 Fürstenfeldbruck (DE)
(74) Vertreter: Heim, Hans-Karl, Dipl.-Ing.

(57) **Zusammenfassung**

Eine Geräteanordnung für Schalt-, Rechner- und Serverschränke weist einen Monitor/Flachbildschirm, eine Tastatur und einen Signalumschalter in einem gemeinsamen Einschub oder in zwei Einzeleinschüben auf. Der Monitor/Flachbildschirm kann in einer herausgefahrenen Betriebsstellung hochgeschwenkt oder aufgeklappt werden. Der Signalumschalter ist bei einem Einschub von einer Höheneinheit zwischen der Tastatur und dem Monitor/Flachbildschirm angeordnet. Bei einem gemeinsamen Einschub von etwa zwei Höheneinheiten oder bei zwei getrennten Einschüben von jeweils maximal einer Höheneinheit sind die Tastatur und ein Signalumschalter in einer Ebene und darüber ein Monitor/Flachbildschirm angeordnet.

## Beschreibung

Die Erfindung betrifft eine Geräte-Anordnung für Schränke der Netzwerktechnik gemäß dem Oberbegriff des Anspruchs 1.

Für Schränke der Netzwerk- und Automatisierungstechnik und insbesondere für Schalt-, Rechner- und Serverschränke ist es bekannt, Tastaturen in Einschüben anzuordnen, welche über Teleskopschienen horizontal verstellbar sind und zur Dateneingabe herausgezogen werden können.

In der Regel weist ein Tastatureinschub eine Höhe von einer Höheneinheit (HE) der 19-Zoll-Bauweise auf. Zusätzlich muß in Serverschränken ein weiterer Einschub für einen Signalumschalter, welcher eine getrennte Ansteuerung mehrerer Server ermöglicht, vorgesehen werden. Der Signalumschalter-Einschub weist in der Regel eine Höhe von einer bis drei Höheneinheiten auf. Des weiteren ist wenigstens ein Datensichtgerät in einem Rechner- oder Serverschrank erforderlich.

Aus der US-PS 5 388 032 ist eine Geräteanordnung für einen Rechnerschrank mit mehreren Rechnern bekannt, bei welchem eine Tastatur und ein Flachbildschirm als Datensichtgerät in einem Einschub angeordnet sind. Der Einschub weist eine Höhe von einer Höheneinheit der 19-Zoll-Bauweise auf. Zwischen der Tastatur in einem frontseitigen Bereich des Einschubs und dem Flachbildschirm in einem rückseitigen Bereich des Einschubs ist eine Trennwand ausgebildet. Ein Diskriminator zur Auswahl eines Rechners ist hinter dem Flachbildschirm angeordnet. Der Diskriminator, welcher von einer Wähleinheit angesteuert wird, verbindet die Tastatur und den Flachbildschirm mit dem ausgewählten Rechner. Als Wähleinheit kann die Tastatur, jedoch auch ein Keypad oder ein Drehschalter dienen, welche dann hinter der Trennwand und im Bereich des Flachbildschirms angeordnet werden.

Als nachteilig, beispielsweise für Umrüst- und Instandhaltungsarbeiten, kann sich die rückseitige Anordnung des Diskriminators auswirken. Auch die aufwendige getrennte Anordnung der Wähleinheit und des Diskriminators vor und hinter dem verstellbaren Flachbildschirms ist als ein Nachteil anzusehen.

Der Erfindung liegt die **Aufgabe** zugrunde, eine Geräteanordnung zu schaffen, welche eine besonders vorteilhafte Anordnung einer Tastatur als Eingabeeinheit, eines Monitors/Flachbildschirms als Datensichtgerät und einer Einrichtung zum Ansteuern und Auswählen eines Rechners in einem Rechner- oder Serverschrank ermöglicht, gleichzeitig das nutzbare Schrankvolumen vergrößert und eine leichte Bedienbarkeit der Geräteanordnung selbst und der Server bzw. Rechner gewährleistet.

Erfindungsgemäß wird die Aufgabe durch die Merkmale des Anspruchs 1 gelöst. Zweckmäßige und vorteilhafte Ausgestaltungen sind in den Unteransprüchen und in der Figurenbeschreibung enthalten.

Die erfindungsgemäße Geräteanordnung weist eine Tastatur, einen Monitor/Flachbildschirm und eine Einrichtung zum Ansteuern und Auswählen eines Rechners und/oder Servers auf, bei welcher als Einrichtung zum Ansteuern und Auswählen eines Rechners und/oder Servers ein Signalumschalter vorgesehen ist. Der Signalumschalter ist bei einem gemeinsamen Einschub von einer Höheneinheit zwischen der Tastatur und dem Monitor/Flachbildschirm angeordnet, wobei die Tastatur in einem frontseitigen Bereich und der Monitor/Flachbildschirm in einem rückseitigen Bereich des Einschubs vorgesehen sind. Indem der Signalumschalter zwischen der Tastatur und dem Flachbildschirm angeordnet wird, ist eine sichere, störungsfreie Verbindung zwischen Tastatur, Signalumschalter und Monitor/Flachbildschirm möglich. Erfindungsgemäß können Tastatur und Monitor/Flachbildschirm auch in einem gemeinsamen Einschub mit einer Höhe von 1,5 bis zu 2 Höheneinheiten oder jeweils in einem Einzeleinschub mit einer Höhe von jeweils etwa einer Höheneinheit angeordnet sein, wobei der Monitor/Flachbildschirm in dem gemeinsamen Einschub von etwa zwei Höheneinheiten oberhalb der Tastatur angeordnet ist. Bei Einzeleinschüben für die Tastatur bzw. den Monitor/Flachbildschirm können diese direkt übereinander oder in einem Abstand von einer oder mehreren Höheneinheiten angeordnet werden.

Tastatur, Monitor/Flachbildschirm und Signalumschalter werden in eingeschobener Stellung des Einschubs von diesem aufgenommen. In herausgezogener Betriebsstellung kann der Monitor/Flachbildschirm schräg oder vertikal aufgestellt werden.

Der Begriff Monitor/Flachbildschirm soll Bildschirme geringer Bautiefe, z.B. Flachbildröhren mit Katodenstrahlablenkung, Raster-Flachbildschirme, Plasma-, LED-, Elektroluminizenzund LCD-Bildschirme umfassen. In der Regel hat ein Flachbildschirm eine Tiefe von etwa 24 mm. Dieser Flachbildschirm wird in einer horizontalen Stellung, z.B. hinter der Tastatur und dem Signalumschalter oder über der Tastatur, angeordnet und bei herausgezogenem Einschub in eine Betriebsstellung gebracht, beispielsweise um eine horizontale, vorzugsweise frontseitige Achse hochgeschwenkt oder auch aufgeklappt.

In der nahezu vertikalen Betriebsstellung sollte der Monitor/Flachbildschirm durch einen Feststeller gesichert werden. Des weiteren ist es sinnvoll, den Einschub vor einem unbeabsichtigten Hineinschieben zu sichern. Es ist vorteilhaft, wenn eine Einrichtung sowohl die Halterung des Monitor/Flachbildschirms in Betriebsstellung als auch die Arretierung des Einschubs in herausgezogener Stellung gewährleistet.

Die Anordnung einer Tastatur, eines Signalumschalters und eines Flachbildschirms in einer Ebene sowie vorteilhafterweise einer Handauflage in einem frontseitigen Bereich des gemeinsamen Einschubs erfordert etwa eine Schranktiefe bzw. Einschubtiefe von ca. 700 mm. Eine derartige Einschubtiefe ist bei Rechnerschränken im Serverbereich gegeben.

Bei einem gemeinsamen Einschub von 1,5 bis maximal 2 Höheneinheiten der 19-Zoll-Bauweise für eine Tastatur und einem darüber angeordneten Flachbildschirm wird hinter der Tastatur zweckmäßigerweise der Signalumschalter angeordnet. Vor der Tastatur kann eine Handauflage vorgesehen sein. Der Flachbildschirm ist zweckmäßigerweise an einem rückseitigen Gelenk oder Scharnier angelenkt und kann nach oben aufgeklappt werden. In der Regel beträgt der Winkel in aufgeklappter Betriebsstellung bis zu etwa 130°. Diese Geräte-Anordnung erfordert lediglich eine Tiefe von etwa 300 mm bis 400 mm.

Eine Tastatur und ein Monitor/ Flachbildschirm können auch in zwei Einzeleinschüben angeordnet werden. Es ist von Vorteil, wenn ein Signalumschalter in dem Einzeleinschub für die Tastatur angeordnet wird. Dabei kann der Signalumschalter unmittelbar hinter der Tastatur, jedoch auch in den Seitenbereichen und in einer vertikalen Anordnung vorgesehen sein.

Die Einzeleinschübe, welche eine Höhe von einer Höheneinheit (1 HE) aufweisen, können unmittelbar übereinander in einem Schrank oder Gestell angeordnet werden. Es besteht jedoch auch die Möglichkeit, die Einzeleinschübe mit einem Abstand von einer oder mehreren Höheneinheiten anzuordnen.

Ein Monitor/Flachbildschirm kann darüber hinaus, insbesondere bei der Ausbildungsvariante mit einem gemeinsamen Einschub von einer oder zwei Höheneinheiten, in Betriebsstellung aus dem gemeinsamen Einschub herausgenommen und auf einer höheren Aufnahme oder einer Auszugsplatte angeordnet werden.

Es ist außerdem vorteilhaft, wenn in dem Einschub für den Monitor/Flachbildschirm auch eine Einrichtung zum Verschwenken des Monitors/Flachbildschirms um eine vertikale Achse vorgesehen ist. Diese Verschwenkeinrichtung kann z.B. abklappbar in einem Seitenbereich des Einschubs angeordnet werden. Darüber hinaus kann es von Vorteil sein, wenn neben der vertikalen Verstellung eine Neigungsverstellung des Monitors/Flachbildschirms vorgesehen wird.

Die Erfindung wird nachstehend anhand einer Zeichnung weiter erläutert; in dieser zeigen in einer stark schematisierten Darstellung
- Fig. 1: eine erfindungsgemäße Geräteanordnung in einer Draufsicht;
- Fig. 2: eine Ansicht der erfindungsgemäßen Geräteanordnung nach Pfeil II gemäß Fig. 1;
- Fig. 3: eine Seitenansicht der erfindungsgemäßen Geräteanordnung nach Pfeil III gemäß Fig. 1, jedoch zusätzlich mit einem hochgestellten Flachbildschirm;
- Fig. 4: eine Seitenansicht einer weiteren Geräteanordnung und
- Fig. 5: eine stark schematisierte Seitenansicht einer weiteren erfindungsgemäßen Geräteanordnung.

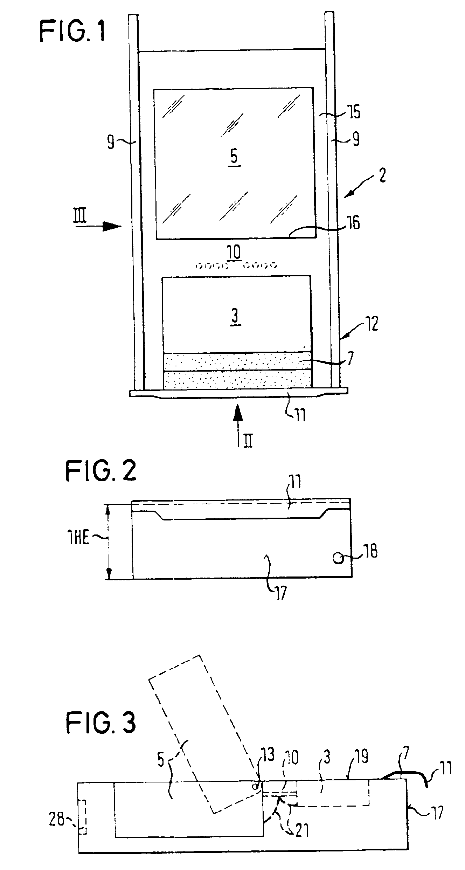

Fig. 1 bis 3 zeigen eine bevorzugte Variante der erfindungsgemäßen Geräteanordnung. In dieser Geräteanordnung sind eine Tastatur 3, ein Signalumschalter 10 und als Datensichtgerät ein Monitor/Flachbildschirm 5 in einem gemeinsamen Einschub 2 aufgenommen. Der gemeinsame Einschub 2 hat eine Höhe von etwa einer Höheneinheit und eine Tiefe von ca. 700 mm.

Die Tastatur 3 ist in einem frontseitigen Bereich 12 des Einschubs 2 angeordnet. Dahinter ist der Signalumschalter 10 und hinter diesem der Monitor/Flachbildschirm 5 (z.B. ein LC-Display) angeordnet. Zwischen einem frontseitigen Handgriff 11 und der Tastatur 3 ist eine Handauflage 7 ausgebildet. Alle vorgenannten Geräte 3, 5, 10 und auch die Handauflage 7 reichen nicht über eine Oberkante 19 des gemeinsamen Einschubs 2 hinaus (siehe Fig. 3).

In einer Frontseite 17 des gemeinsamen Einschubs 2 ist in diesem Beispiel eine Verriegelungseinrichtung, z.B. ein Schließzylinder 18, vorgesehen, um ein unberechtigtes Herausziehen des Einschubs 2 und eine unbefugte Datenein- und -ausgabe zu verhindern.

Der gemeinsame Einschub 2 ist über beidseitig angeordnete Teleskopschienen 9 horizontal verstellbar und kann aus einem Schrank oder Gestell (nicht dargestellt) herausgezogen und wieder hineingeschoben werden. In der herausgezogenen Stellung sind die Tastatur 3, der Signalumschalter 10 und der Monitor/Flachbildschirm zugänglich.

Fig. 3 zeigt mit strichlierten Linien eine Betriebsstellung des Monitors/Flachbildschirms 5, in welche dieser aus der horizontalen Anordnung durch Aufschwenken gebracht wird. Das Aufstellen des Flachbildschirms 5 ist relativ einfach um eine frontseitige horizontale Achse 13 möglich. Eine Verkabelung 21 führt vom Signalumschalter 10 zum Flachbildschirm 5 und zur Tastatur 3.

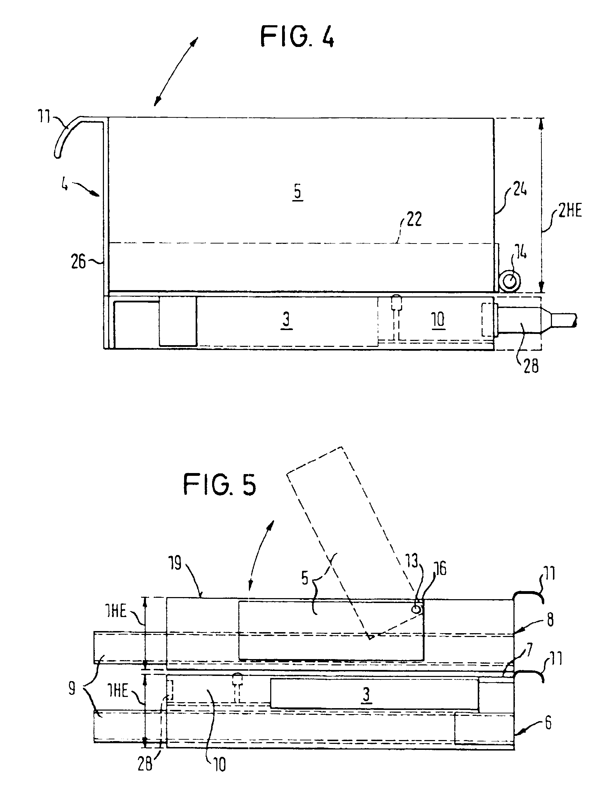

Fig. 4 zeigt eine weitere Geräteanordnung in einem gemeinsamen Einschub. Der gemeinsame Einschub 4 weist hier jedoch eine Höhe von 1,5 bis 2 Höheneinheiten auf, wobei eine Tastatur 3 und ein Signalumschalter 10 eine Höhe < 1 HE aufweisen. Eine strichlierte Linie 22 gibt eine Höheneinheit (1 HE) an.

Oberhalb der Tastatur 3 und des Signalschalters 10 ist der Flachbildschirm 5 angeordnet und über ein Scharnier 14 in einem rückseitigen Bereich 24 des Einschubs 4 angelenkt. Der Flachbildschirm 5 kann in aufgeklappter Stellung mit einem Öffnungswinkel von etwa 130 o angeordnet werden und gewährleistet eine gute Ablesbarkeit. In einem frontseitigen Bereich 26 und vor der Tastatur 3 ist eine Handauflage 7 ausgebildet, welche wie die Tastatur 3 und der Signalumschalter 10 in eingeschobener Position des gemeinsamen Einschubs 4 von dem darüber geklappten Flachbildschirm 5 abgedeckt wird. Der gemeinsame Einschub 4 ist über einen Handgriff 11 betätigbar, welcher nach einer Entriegelung (nicht dargestellt) auch zum Hochklappen des Flachbildschirms 5 verwendet werden kann. An der Rückseite 24 ist ein Anschluß 28 für den Signalumschalter 10 angeordnet.

Eine weitere Geräte-Anordnung ist in Fig. 5 gezeigt. Gleiche Merkmale sind wiederum mit identischen Bezugszeichen versehen.

Bei der Geräteanordnung nach Fig. 5 ist für eine Tastatur 3 ein Einzeleinschub 6 und für einen Flachbildschirm 5 ein weiterer Einzeleinschub 8 vorgesehen. Hinter der Tastatur 3 befindet sich wiederum ein Signalumschalter 10 mit einem Anschluß 28. Vor dem Flachbildschirm 5 ist eine Handauflage 7 ausgebildet. Die Einzeleinschübe 6, 8 weisen eine Höhe von jeweils etwa einer Höheneinheit auf und können gemäß Fig. 5 direkt übereinander, jedoch auch beabstandet voneinander in einem Schrank oder Gestell angeordnet werden. Der Flachbildschirm 5 kann auch aus dem Einschub 8 entnommen und auf einer anderen, insbesondere höheren Ebene des Schrankes, angeordnet werden.

## Patentansprüche

1. Geräte-Anordnung für Schränke und Gestelle der Netzwerk- und Automatisierungstechnik, in denen mehrere Rechner und/oder Server angeordnet sind,
mit wenigstens einem Einschub (2, 4, 6, 8), in welchem eine Tastatur (3), ein Monitor/Flachbildschirm (5) und eine Einrichtung zur Ansteuerung eines Rechners oder Servers angeordnet sind, und
bei welcher der Monitor/Flachbildschirm (5) aus einer horizontalen Stellung bei eingeschobenem Einschub (2, 4, 8) in eine vertikale oder schräge Betriebsstellung bei herausgezogenem Einschub (2, 4, 8) verstellbar ist,
dadurch **gekennzeichnet,**
daß als Einrichtung zur Ansteuerung der Rechner und/ oder Server ein Signalumschalter (10) vorgesehen ist,
daß die Tastatur (3), der Monitor/Flachbildschirm (5) und der Signalumschalter (10) in einem gemeinsamen Einschub mit einer Höhe von etwa einer Höheneinheit der 19-Zoll-Bauweise (2) angeordnet sind, wobei die Tastatur (3) in einem frontseitigen Bereich (12), der Monitor/Flachbildschirm (5) in einem rückseitigen Bereich (24) des Einschubs (2) und der Signalumschalter (10) zwischen der Tastatur (3) und dem Monitorflachbildschirm angeordnet sind, oder
daß die Tastatur (3) und der Monitor/Flachbildschirm (5) in einem gemeinsamen Einschub (4) mit einer Höhe von etwa zwei Höheneinheiten der 19-Zoll-Bauweise oder jeweils in einem Einzeleinschub (6, 8) mit einer Höhe von jeweils etwa einer Höheneinheit der 19-Zoll-Bauweise angeordnet sind,
daß bei dem gemeinsamen Einschub (4) von etwa zwei Höheneinheiten der Monitor/Flachbildschirm (5) oberhalb der Tastatur angeordnet ist, und
daß die Einzeleinschübe (6, 8) für die Tastatur (3) und den Monitor/Flachbildschirm (5) direkt übereinander oder in einem Abstand von einer oder mehreren Höheneinheiten angeordnet sind.

2. Geräte-Anordnung nach Anspruch 1,
dadurch **gekennzeichnet,**
daß der Monitor/Flachbildschirm (5) des gemeinsamen Einschubs (4) von zwei Höheneinheiten um ein Scharnier (14), welches rückseitig angeordnet ist, aufklappbar ist und daß die horizontale Achse (13) des Monitors/ Flachbildschirms (5) des gemeinsamen Einschubs (2) von einer Höheneinheit und des Einzeleinschubs (8) an einem frontseitigen Bereich (16) des Monitors/Flachbildschirms (5) angeordnet ist.

3. Geräte-Anordnung nach Anspruch 1 oder 2,
dadurch **gekennzeichnet,**
daß der Monitor/Flachbildschirm (5) wenigstens aufklappbar oder um eine horizontale Achse (13) schwenkbar angeordnet ist.

4. Geräte-Anordnung nach einem der vorhergehenden Ansprüche,
dadurch **gekennzeichnet,**
daß der Monitor/Flachbildschirm (5) der gemeinsamen Einschübe (2; 4) und des Einzeleinschubs (8) in Betriebsstellung außerhalb des Einschubs (2; 4; 8) und insbesondere oberhalb des Einschubs (2; 4; 8) auf einem Auszug oder einem Zwischenboden angeordnet ist.

5. Geräte-Anordnung nach einem der vorhergehenden Ansprüche,
dadurch **gekennzeichnet,**
daß die gemeinsamen Einschübe (2; 4) und wenigstens der Einzeleinschub (8) für den Monitor/Flachbildschirm (5) eine Einrichtung (15) zur Sicherung der Einschübe (2; 4; 8) in der ausgefahrenen Stellung und des vertikal oder schräg gestellten Monitors/Flachbildschirms (5) aufweist.

6. Geräte-Anordnung nach einem der vorhergehenden Ansprüche,
dadurch **gekennzeichnet,**
daß der Monitor/Flachbildschirm (5) nach dem Aufstellen um eine vertikale Achse verschwenkbar und/oder neigungsverstellbar angeordnet ist.

7. Geräte-Anordnung nach einem der vorhergehenden Ansprüche,
dadurch **gekennzeichnet,**
daß in dem gemeinsamen Einschub (4) von etwa zwei Höheneinheiten und in dem Einzeleinschub (6) für die Tastatur (3) ein Signalumschalter (10) jeweils hinter der Tastatur (3) angeordnet ist.

8. Geräte-Anordnung nach einem der vorhergehenden Ansprüche,
dadurch **gekennzeichnet,**
daß der Signalumschalter (10) neben der Tastatur (3) und in Randbereichen der Einschübe (2; 4; 6), in denen die Tastatur (3) aufgenommen ist, angeordnet ist.

9. Geräte-Anordnung nach einem der vorhergehenden Ansprüche,
dadurch **gekennzeichnet,**
daß die gemeinsamen Einschübe (2; 4) und der Einzeleinschub (6) mit Tastatur (3) eine Handauflage (7) aufweisen, welche vor der Tastatur (3) in einem frontseitigen Bereich (12) angeordnet ist.

10. Geräte-Anordnung nach einem der vorhergehenden Ansprüche,
dadurch **gekennzeichnet,**
daß der gemeinsame Einschub (2) mit hintereinander angeordneter Tastatur (3), Signalumschalter (10) und Monitor/Flachbildschirm (5) eine Tiefe von ca. 700 mm aufweist.

11. Geräte-Anordnung nach einem der vorhergehenden Ansprüche,
dadurch **gekennzeichnet,**
daß der gemeinsame Einschub (4) von etwa zwei Höheneinheiten und die Einzeleinschübe (6, 8) eine Tiefe von etwa 300 mm bis 400 mm aufweisen.
